# EUROPEAN PATENT APPLICATION

(11) **EP 2 372 781 A1**
(43) Date of publication of application: **05.10.2011**
(21) Application number: 09834479.9
(22) Date of filing: 24.12.2009
(51) Int. Cl.: H01L 31/042, C08K 3/22, C08L 23/22, C09K 3/10

(54) **SEALANT FOR SOLAR CELL PANEL END, SOLAR CELL MODULE, FRAMELESS SOLAR CELL MODULE, AND SEALNG STRUCTURE AT SOLAR CELL PANEL END**

(30) Priority: 26.12.2008 JP 2008334461; 18.12.2009 JP 2009287875
(71) Applicant: Nitto Denko Corporation, Ibaraki-shi Osaka 567-8680 (JP)
(72) Inventor: FUJII, Hiroki, Ibaraki-shi Osaka 567-8680 (JP)
(74) Representative: Schwabe - Sandmair - Marx
(86) International application number: PCT/JP2009/007202
(87) International publication number: WO 2010/073673

(57) **Abstract**

A sealant for solar cell panel end is for sealing an end of a solar cell panel, and contains 100 parts by weight of polyisobutylene and/or butyl rubber, and 100 to 600 parts by weight of a metal hydroxide.

## Description

### TECHNICAL FIELD

The present invention relates to a sealant for solar cell panel end, a solar cell module, a frameless solar cell module, and a sealing structure at solar cell panel end, and particularly to a sealant for solar cell panel end for sealing an end of a solar cell panel, a solar cell module, a frameless solar cell module, and a sealing structure at solar cell panel end.

### BACKGROUND ART

Conventionally, a peripheral end of a solar cell panel is typically fixed with a fixing member having a generally U-shaped cross-sectional shape. Between the peripheral end of the solar cell panel and the fixing member, a sealant is interposed.
Examples of such a sealant that have been proposed include a sealing material for solar cell panel which contains polyisobutylene, carbon black, and a tackifier (see, e.g., Patent Document 1 shown below).

To fix a peripheral end of a solar panel using the sealing material proposed in Patent Document 1 shown below, the sealing material is stuck to the peripheral end of the solar panel or to a fixing member. Then, while heating and melting the sealing material, the peripheral end of the solar panel is inserted into the fixing member to be assembled therewith. Thereafter, the sealing material is cooled at room temperature.

### PRIOR ART DOCUMENT

### PATENT DOCUMENT

Patent Document 1: Japanese Patent Publication No. 2006-117758

### SUMMARY OF THE INVENTION

### PROBLEMS TO BE SOLVED BY THE INVENTION

The sealing material proposed in Patent Document 1 mentioned above has low shape conformability (adhesion) at room temperature. Accordingly, when the sealing material is fixed to the fixing member at the peripheral end of the solar panel, the sealing material needs to be temporarily heated to be melted, and then cooled. Additionally, for the sealing material, extra time for heating and cooling needs to be provided.
When the sealing material is fixed to the fixing member at the peripheral end of the solar panel, the sealing material is melted by heating, which leads to a problem that the sealing material spreads out of the fixing member to result in dripping.

The solar cell panel (solar panel) is used also in a high-temperature atmosphere and, in that case, the viscosity of the sealing material excessively deteriorates. This leads to a problem that the sealing material spreads out of the fixing member to result in dripping.
An object of the present invention is to provide a sealant for solar cell panel end which can easily seal an end of a solar cell panel in a short time, has excellent shape stability in a high-temperature atmosphere, and also has an excellent insulating property, waterproofness, and flame retardancy, a solar cell module, a frameless solar cell module, and a sealing structure at solar cell panel end.

### MEANS FOR SOLVING THE PROBLEMS

To attain the object, a sealant for solar cell panel end of the present invention is a sealant for solar cell panel end for sealing an end of a solar cell panel, and contains 100 parts by weight of polyisobutylene and/or butyl rubber, and 100 to 600 parts by weight of a metal hydroxide.
It is preferable that the sealant for solar cell panel end of the present invention further contains 100 to 200 parts by weight of a softener based on 100 parts by weight of the polyisobutylene and/or the butyl rubber.

In the sealant for solar cell panel end of the present invention, it is preferable that a storage shear modulus (G') is not less than 3 x10⁴ and not more than 2 x 10⁶ in a temperature range of 0 to 100 °C.
In the sealant for solar cell panel end of the present invention, it is preferable that a dielectric breakdown voltage measured based on a dielectric breakdown voltage test defined in JIS C2110 is not less than 8 kV.

A solar cell module of the present invention includes a solar cell panel, a sealant for solar cell panel end which seals an end of the solar cell panel, and contains 100 parts by weight of polyisobutylene and/or butyl rubber, and 100 to 600 parts by weight of a metal hydroxide, and a fixing member which fixes the end of the solar cell panel via the sealant for solar cell panel end.

In the solar cell module of the present invention, it is preferable that the solar cell panel includes a solar cell element, a sealing resin layer which seals the solar cell element, and a covering glass layer which covers the sealing resin layer on both sides thereof in a thickness direction, wherein the sealant for solar cell panel end is stuck continuously to at least a side surface of the sealing resin layer and a side surface of the covering glass layer.
A frameless solar cell module of the present invention includes a solar cell panel, and a sealant for solar cell panel end which seals an end of the solar cell panel, and contains 100 parts by weight of polyisobutylene and/or butyl rubber, and 100 to 600 parts by weight of a metal hydroxide.

In the frameless solar cell module of the present invention, it is preferable that the solar cell panel includes a solar cell element, a sealing resin layer sealing the solar cell element, and a covering glass layer which covers the sealing resin layer on both sides thereof in a thickness direction, and has a perpendicular end perpendicular to the thickness direction and protruding from the sealing resin layer, and the sealant for solar cell panel end is disposed so as to surround the sealing resin layer when projected in the thickness direction, and fills the perpendicular end of the covering glass layer.

In a sealing structure at solar cell panel end of the present invention, an end of a solar cell panel is fixed with a fixing member via a sealant for solar cell panel end comprising 100 parts by weight of polyisobutylene and/or butyl rubber, and 100 to 600 parts by weight of a metal hydroxide.
In a sealing structure at solar cell panel end of the present invention, an end of a solar cell panel is filled with a sealant for solar cell panel end comprising 100 parts by weight of polyisobutylene and/or butyl rubber, and 100 to 600 parts by weight of a metal hydroxide.

### EFFECT OF THE INVENTION

The sealant for solar cell panel end of the present invention has excellent shape conformability at room temperature, and therefore can reliably seal the end of the solar cell panel of the solar cell module and/or frameless solar cell module of the present invention at room temperature. In addition, the sealant for solar cell panel end need not be heated when stuck to the end of the solar cell panel, and can easily seal the end of the solar cell panel of the solar cell module and/or frameless solar cell module.

The sealant for solar cell panel end also has excellent shape stability in a high-temperature atmosphere, and therefore it is possible to prevent dripping when the solar cell panel of the solar cell module and/or frameless solar cell module is used in a high-temperature atmosphere.
Moreover, the sealant for solar cell panel end also has an excellent insulating property, waterproofness, and flame retardancy, and therefore it is possible to impart an excellent insulating property, waterproofness, and flame retardancy to the end of the solar cell panel of the solar cell module and/or frameless solar cell module.

In the sealing structure at solar cell panel end of the present invention, the end of the solar cell panel of the solar cell module is reliably fixed with the fixing member via the sealant for solar cell panel end, and therefore the end of the solar cell panel can be more reliably sealed. This allows an improvement in the sealability of the end of the solar cell panel.
In the sealing structure at solar cell panel end of the present invention, the sealant for solar cell panel end of the frameless solar cell module can be easily stuck to a peripheral end of the solar cell panel. Therefore, it is possible to easily seal the end of the solar cell panel, while achieving reductions in the weight and cost of the frameless solar cell module.

### BRIEF DESCRIPTION OF THE DRAWINGS

[FIG. 1] FIG. 1 shows a cross-sectional view of an embodiment of a sealant for solar cell panel end of the present invention.
[FIG. 2] FIG. 2 is an illustrative view of a method of sealing a peripheral end of a solar cell panel with the sealant for solar cell panel end shown in FIG. 1,
   (a) showing the step of sticking the sealant for solar cell panel end to the peripheral end of the solar cell panel, and
   (b) showing the step of inserting the peripheral end of the solar cell panel into a frame.
[FIG. 3] FIG. 3 shows a partially cross-sectional perspective view of an embodiment of a solar cell module of the present invention.
[FIG. 4] FIG. 4 shows an embodiment (mode in which the sealant for solar cell panel end includes four pieces) of a frameless solar cell module of the present invention,
   (a) showing a cross-sectional view thereof,
   (b) showing a plan view thereof, and
   (c) showing a partially cut-away cross-sectional perspective view thereof.
[FIG. 5] FIG. 5 is a process step view for illustrating a method of producing the frameless solar cell module shown in FIG. 4(a),
   (a) showing the step of preparing an upper covering glass layer,
   (b) showing the step of disposing a solar cell element,
   (c) showing the step of disposing a sealing resin layer,
   (d) showing the step of disposing the sealant for solar cell panel end, and
   (e) showing the step of disposing a lower covering glass.

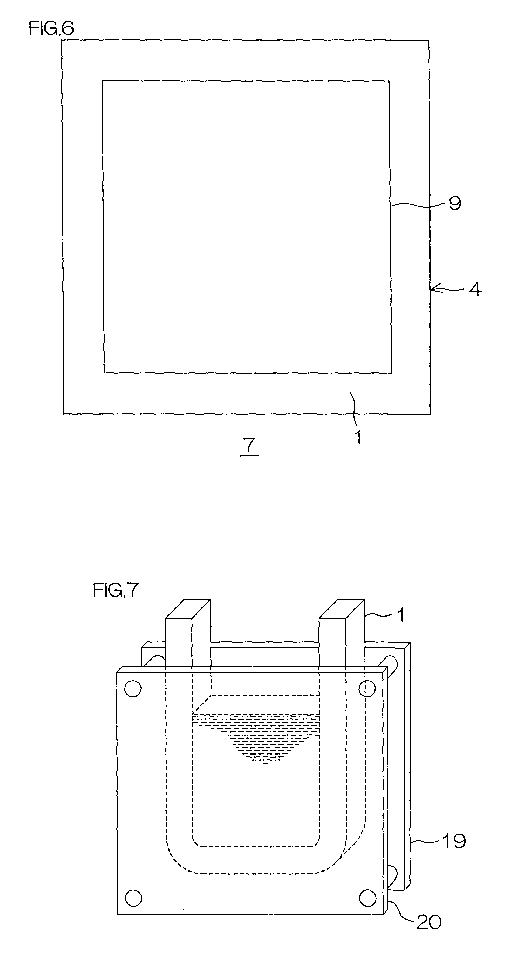

[FIG. 6] FIG. 6 shows a plan view of another embodiment (mode in which the sealant for solar cell panel end includes one piece) of the frameless solar cell module of the present invention.
[FIG. 7] FIG. 7 is an illustrative view of a waterproofness test in Examples.

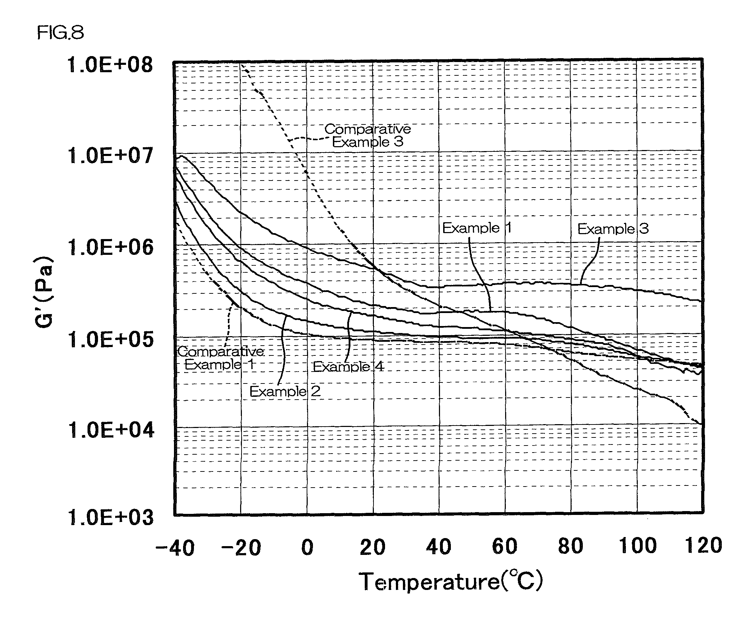

[FIG. 8] FIG. 8 is a graph of storage shear moduli G' obtained by a viscoelasticity test in Examples.

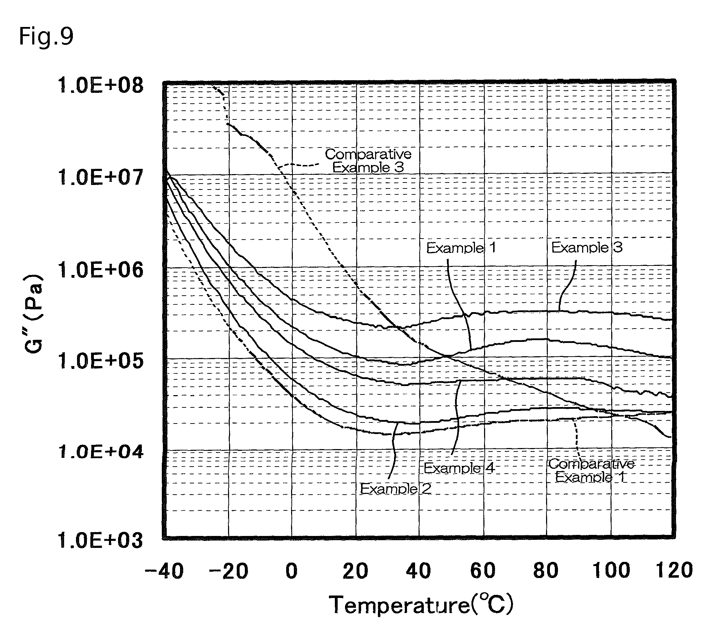

[FIG. 9] FIG. 9 is a graph of loss shear moduli G" obtained by the viscoelasticity test in Examples.

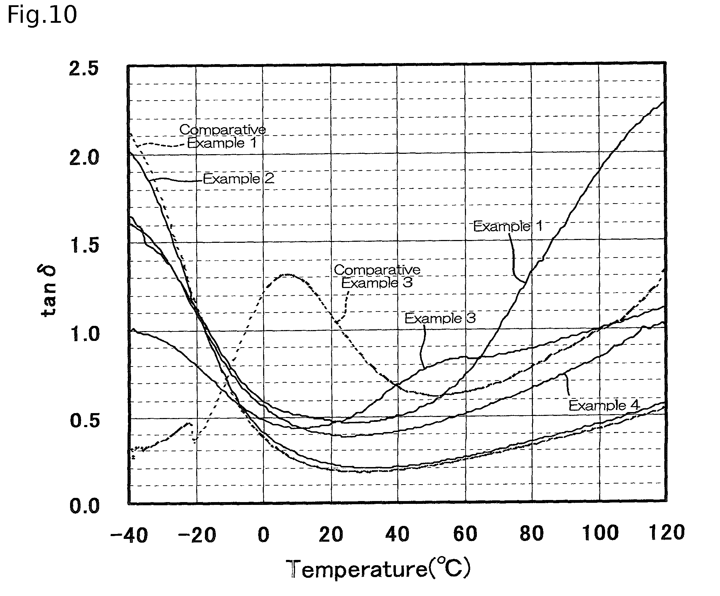

[FIG. 10] FIG. 10 is a graph of loss tangents tanδ obtained by the viscoelasticity test in Examples.

### EMBODIMENTS FOR CARRYING OUT THE INVENTION

A sealant for solar cell panel end of the present invention is a sealant for sealing a peripheral end of a solar cell panel, and contains polyisobutylene and/or butyl rubber, and a metal hydroxide.
Polyisobutylene is a polymer of isobutylene. Polyisobutylene has a viscosity-average molecular weight thereof in a range of, e.g., 200,000 to 4,000,000, or preferably 500,000 to 1,500,000.

Butyl rubber is a copolymer (isobutylene-isoprene rubber) of isobutene (isobutylene) and a small amount of isoprene. Butyl rubber has a viscosity-average molecular weight thereof in a range of, e.g., 300,000 to 700,000, or preferably 300,000 to 500,000.
Of polyisobutylene and butyl rubber, both or either one is contained in the sealant for solar cell panel end of the present invention.

Preferably, polyisobutylene is contained in the sealant for solar cell panel end. When polyisobutylene is contained in the sealant for solar cell panel end, an advantage of improved water resistance is offered.
The metal hydroxide is a flame retardant for imparting flame retardancy to the sealant for solar cell panel end.

Examples of the metal hydroxide that can be used include aluminum hydroxide, magnesium hydroxide, calcium hydroxide, nickel hydroxide, cobalt hydroxide, tin hydroxide, zinc hydroxide, copper hydroxide, iron hydroxide, and titanium hydroxide. These metal hydroxides can be used alone or in combination of two or more kinds.
Among these metal hydroxides, in terms of a high flame retardant effect at a low temperature, aluminum hydroxide is preferably used.

The metal hydroxide has an average particle diameter in a range of, e.g., 0.1 to 10 µm, or preferably 0.5 to 5 µm. The average particle diameter can be measured with, e.g., a laser-type particle size measuring device.
The blending proportion of the metal peroxide based on 100 parts by weight of polyisobutylene and/or butyl rubber is in a range of, 100 to 600 parts by weight, or preferably 100 to 500 parts by weight.
When the blending proportion of the metal hydroxide is less than the range shown above, flame retardancy deteriorates. On the other hand, when the blending proportion of the metal hydroxide exceeds the range shown above, moldability or workability deteriorates.

Preferably, the sealant for solar cell panel end of the present invention further contains a softener.
The softener is contained as necessary in the sealant for solar cell panel end to improve moldability or workability.
Examples of the softener that can be used include polybutene (specifically liquid polybutene), low-molecular-weight polyisobutylene (having a molecular weight of, e.g., not more than 100,000), oils (such as naphthene-based oil), paraffins, waxes, aromatic oils, asphalts, drying oils, and animal/vegetable oils.

These softeners can be used alone or in combination of two or more kinds.
Preferably, in terms of miscibility with polyisobutylene and/or butyl rubber, polybutene is used or, preferably, in terms of ensuring a low-temperature property, naphthene-based oil is used. More preferably, polybutene and naphthene-based oil are used in combination. In that case, polybutene (liquid polybutene) and naphthene-based oil are preferably blended in respective proportions of 50 to 80 wt% and 20 to 50 wt% based on the total amount of the softeners.

The blending proportion of the softener is in a range of, e.g., 50 to 300 parts by weight, preferably 50 to 250 parts by weight, or more preferably 100 to 200 parts by weight based on, e.g., 100 parts by weight of polyisobutylene and/or butyl rubber. When the blending proportion of the softener is less than the range shown above, moldability or workability may not be able to be improved. When the blending portion of the softener exceeds the range shown above, an insulating property or flame retardancy may not be able to be improved.

Also, to the sealant for solar cell panel end of the present invention, such additives as a filler (such as calcium carbonate), a pigment (such as carbon black), a lubricant (such as tallow hardened fatty acid), and an antiaging agent (such as hindered phenol-based antiaging agent) can be added.
These additives can be used alone or in combination of two or more kinds. The blending (adding) proportions of the filler, the pigment, the lubricant, and the antiaging agent based on 100 parts by weight of polyisobutylene and/or butyl rubber are in respective ranges of, e.g., 1 to 100 parts by weight, e.g., 0.1 to 10 parts by weight, e.g., 0.1 to 5 parts by weight, and, e.g., 0.1 to 5 parts by weight.

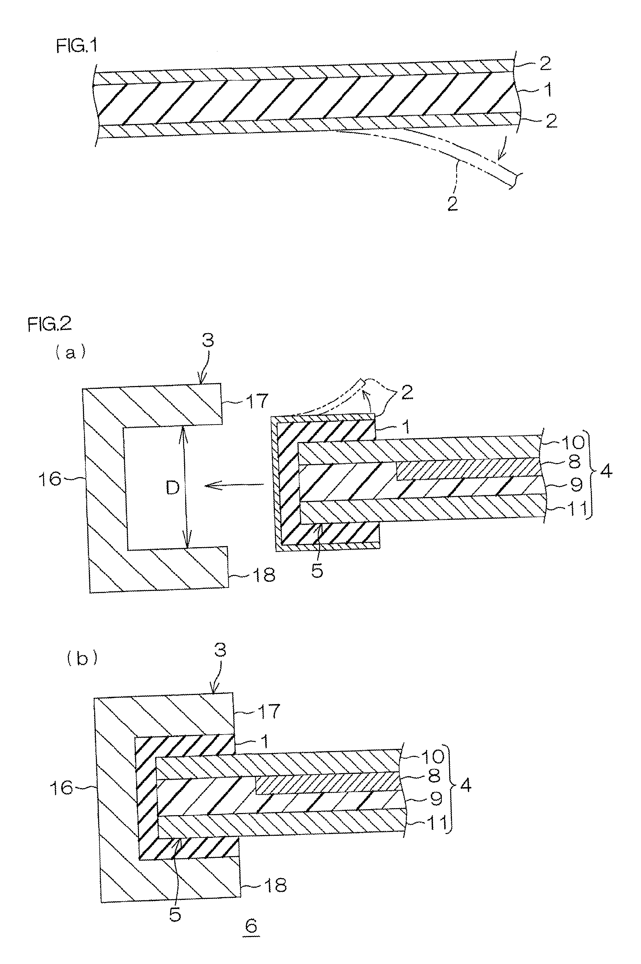

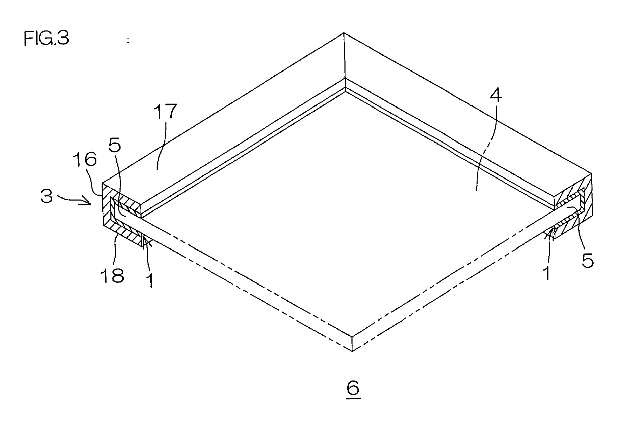

FIG. 1 shows a cross-sectional view of an embodiment of the sealant for solar cell panel end of the present invention. FIG. 2 shows an illustrative view of a method of sealing a peripheral end of a solar cell panel with the sealant for solar cell panel end shown in FIG. 1. FIG. 3 shows a partially cross-sectional perspective view of an embodiment of a solar cell module of the present invention.
Next, a method for obtaining a sealant for solar cell panel end 1 of the present invention is described with reference to FIG. 1.

To obtain the sealant for solar cell panel end 1 of the present invention, the individual components described above are blended in the proportions shown above, heated, and kneaded to obtain a kneaded product.
For the kneading, there is used, e.g., a batch-type kneader such a kneader, a Banbury mixer, or a mixing roll, a continuous kneader such as a double-shaft kneader, or the like. A heating temperature in the kneading is in a range of, e.g., 80 to 120 °C, or preferably 90 to 110 °C.

Also for the kneading, a master batch method (divided charging method) can be used. In the master batch method, a part of the metal hydroxide and parts of the components other than the metal hydroxide are first blended together, and evenly stirred to produce a master batch and, with the master batch, the remaining part of the metal hydroxide and the remaining parts of the components other than the metal hydroxide are blended, and evenly stirred.
After the kneading, the obtained kneaded product is heated, and molded into a sheet shape with a molding device such as, e.g., an extruder, a calender roll, or a presser (heat presser), and the obtained molded product is laminated on a surface of an exfoliate film 2. Preferably, the extruder or the calender roll is used, or more preferably, the extruder is used.

The sealant for solar cell panel end 1 thus obtained is formed into an elongated flat belt shape extending in a longitudinal direction.
The thickness of the sealant for solar cell panel end 1 is selectively determined appropriately in accordance with the dimensions of a solar cell panel 4 and a frame 3 described later as shown in FIG. 2(a), and in a range of, e.g., 0.3 to 5.0 mm, or preferably 0.5 to 3.0 mm.

The width (length in a direction perpendicular to the direction in which the frame 3 described later extends) of the sealant for solar cell panel end 1 is selectively determined appropriately in accordance with the dimensions of the frame 3, and in a range of, e.g., 10 to 50 mm, or preferably 20 to 40 mm.
Thereafter, on the surface (surface opposite to the back surface on which the exfoliate film 2 has been already laminated) of the sealant for solar cell panel end 1, another exfoliate film 2 is additionally laminated.

In this manner, as shown in FIG. 1, the sealant for solar cell panel end 1 having the exfoliate films 2 laminated on the both surfaces thereof is obtained.
The sealant for solar cell panel end 1 thus obtained has an oxygen index measured in accordance with JIS K6269 which is in a range of, e.g., not less than 20, preferably not less than 25, or more preferably not less than 30, and normally not more than 50. When the oxygen index is within the range shown above, it is possible to prevent continuous burning of the sealant for solar cell panel end 1.

Also, the sealant for solar cell panel end 1 has a storage shear modulus (G') in a temperature range of 0 to 100 °C which is in a range of, e.g., not less than 3x10⁴ and not more than 2 x 10⁶, or preferably not less than 4 x 10⁴ and not more than 1 x 10⁶. The storage shear modulus (G') thereof in a temperature range of 0 to 80 °C is in a range of, e.g., not less than 5 x 10⁴ and not more than 2 x 10⁶, or preferably not less than 6 x 10⁴ and not more than 1 x 10⁶.
When the storage shear modulus (G') is less than the range shown above, dripping may occur during use in a high-temperature atmosphere. On the other hand, when the storage shear modulus (G') exceeds the range shown above, adhesion to the solar cell panel 4 may deteriorate.

The storage shear modulus (G') is described later in detail in subsequent Examples, and calculated by a viscoelasticity test in which a temperature increasing rate is 5 °C/min, a frequency is 1.0 Hz, and a distortion is 0.1%.
Also, the sealant for solar cell panel end has a loss shear modulus (G") in a temperature range of 0 to 100 °C which is in a range of, e.g., not less than 1 x 10⁴ and not more than 1 x 10⁶, or preferably not less than 1 x 10⁴ and not more than 5 x 10⁵.

When the loss shear modulus (G") is in the range shown above, it is possible to prevent dripping during use in a high-temperature atmosphere, and excellently retain the adhesion to the solar cell panel 4.
The loss shear modulus (G") is calculated simultaneously with the storage shear modulus (G') described above.
Also, the sealant for solar cell panel end 1 has a dielectric breakdown voltage measured based on a dielectric breakdown voltage test defined in JIS C2110 which is in a range of, e.g., not less than 8 kV, preferably not less than 10 kV, or more preferably not less than 12 kV, and normally not more than 3 0 kV.

When the dielectric breakdown voltage is less than the range shown above, dielectric breakdown may occur during use.
Next, a method of sealing a peripheral end 5 of the solar cell panel 4 using the sealant for solar cell panel end 1 to produce a solar cell module 6 is described with reference to FIGS. 1 to 3.

In the method, as shown by the imaginary line of FIG. 1, the one (on the back surface side) of the exfoliate films 2 laminated on the sealant for solar cell panel end 1 is stripped first from the back surface of the sealant for solar cell panel end 1.
Then, as shown in FIG. 2(a), the sealant for solar cell panel end 1 is stuck to the peripheral end 5 of the solar cell panel 4.

As shown by the imaginary line of FIG. 3, the solar cell panel 4 is formed in a generally rectangular flat-plate or sheet (panel) shape. As shown in FIG. 2(a), the solar cell panel 4 includes a solar cell element 8, a sealing resin layer 9, and an upper covering glass layer 10 and a lower covering glass layer 11 each serving as a covering glass layer.
Examples of the solar cell element 8 that can be used include known solar cell elements such as a crystalline-silicon solar cell element and an amorphous-silicon solar cell element.
The solar cell element 8 has a generally rectangular flat-plate shape and a thickness in a range of, e.g., 0.15 to 0.20 mm.

The sealing resin layer 9 seals the solar cell element 8. More specifically, in the sealing resin layer 9, the solar cell element 8 is buried such that the upper surface thereof is exposed.
Examples of a resin for forming the sealing resin layer 9 that can be used include ethylene-vinyl acetate copolymer (EVA), polyvinyl butyral (PVB), and polyvinylidene fluoride. Preferably, EVA is used.

The sealing resin layer 9 has a generally rectangular shape larger than the solar cell element 8 when viewed in plan view. The thickness of the sealing resin layer 9 is larger than that of the solar cell element 8, and in a range of, e.g., 0.25 to 2 mm.
The upper covering glass layer 10 is provided on the uppermost surface (upper surface) side of the solar cell panel 4. Specifically, the upper covering glass layer 10 is laminated on the sealing resin layer 9 so as to cover the sealing resin layer 9 and the solar cell element 8 from thereabove. The upper covering glass layer 10 has a generally rectangular shape of the same size as that of the sealing resin layer 9 when viewed in plan view. The upper covering glass layer 10 is formed such that the peripheral end surface thereof is flush with the peripheral end surface of the sealing resin layer 9 in a thickness direction. The thickness of the upper covering glass layer 10 is in a range of, e.g., 0.5 to 12 mm.

The lower covering glass layer 11 is provided on the backmost surface (lower surface) side of the solar cell panel 4. Specifically, the lower covering glass layer 11 is laminated beneath the sealing resin layer 9 such that the sealing resin layer 9 is sandwiched between the lower covering glass layer 11 and the upper covering glass layer 10 located on both sides thereof in the thickness direction. The lower covering glass layer 11 has a generally rectangular shape of the same size as that of the sealing resin layer 9 when viewed in plan view. The lower covering glass layer 11 is formed such that the peripheral end surface thereof is flush with the peripheral end surface of the sealing resin layer 9 in the thickness direction. The thickness of the lower covering glass layer 11 is in a range of, e.g., 0.5 to 12 mm.

The thickness of the solar cell panel 4 is in a range of, e.g., 2 to 10 mm, or preferably 4 to 6 mm.
To stick the sealant for solar cell panel end 1 to the peripheral end 5 of the solar cell panel 4, the back surface (from which the exfoliate film 2 has been stripped) of the sealant for solar cell panel end 1 is stuck to the peripheral end 5 of the solar cell panel 4 to have a generally U-shaped cross-sectional shape covering the side surface, upper surface, and lower surface thereof.

Thereafter, as shown by the imaginary line of FIG. 2(a), the other exfoliate film 2 (on the top surface side) laminated on the sealant for solar cell panel end 1 is stripped from the top surface of the sealant for solar cell panel end 1.
Then, as shown by the arrow of FIG. 2(a) and in FIG. 2(b), the peripheral end 5 of the solar cell panel 4 covered with the sealant for solar cell panel end 1 is inserted into the frame 3 as a fixing member.

As shown in FIGS. 2 and 3, the frame 3 is provided along each of the sides of the solar cell panel 4. The frame 3 is formed in a generally U-shaped cross-sectional shape which is inwardly open toward the solar cell panel 4. That is, the frame 3 integrally includes a side wall 16 having a flat plate shape, an upper wall 17 having a flat plate shape inwardly extending from an upper portion of the side wall 16, and a lower wall 18 having a flat plate shape inwardly extending from a lower portion of the side wall 16. The frame 3 is formed of, e.g., a metal material (such as aluminum) or a resin material (such as acrylic resin), and is preferably formed of the metal material.

As shown in FIG. 3, the frame 3 is assembled such that the longitudinal ends thereof along the individual sides are joined to each other to form four angles, and assume a generally rectangular frame shape when viewed in plan view.
The dimensions of the frame 3 are set appropriately in accordance with the dimensions of the solar cell panel 4, and a distance D (FIG. 2(a)) between the upper wall 17 and the lower wall 18 facing each other is in a range of, e.g., 5 to 30 mm, or preferably 10 to 20 mm.

To insert the peripheral end 5 of the solar cell panel 4 covered with the sealant for solar cell panel end 1 into the frame 3, the peripheral end 5 of the solar cell panel 4 is press-fit into the frame 3 so as to be held in sandwiched relation between the upper wall 17 and the lower wall 18 of the frame 3 via the sealant for solar cell panel end 1. In the insertion, an atmosphere or the temperature of the sealant for solar cell panel end 1 is not particularly limited. For example, the sealant for solar cell panel end 1 is set at a temperature for which heating need not be performed. A specific temperature range is -20 to 40 °C, e.g., 0 to 35 °C, or preferably 10 to 30 °C (specifically, room temperature).

As a result, the sealant for solar cell panel end 1 is held in sandwiched relation by the frame 3, and the peripheral end 5 of the solar cell panel 4 is fixed to the frame 3 via the sealant for solar cell panel end 1.
In this manner, the peripheral end 5 of the solar cell panel 4 is sealed with the sealant for solar cell panel end 1, and a solar cell module 6 including the solar cell panel 4, the sealant for solar cell panel end 1, and the frame 3 can be obtained.

The sealant for solar cell panel end 1 has excellent shape conformability at room temperature, and therefore can reliably seal the peripheral end 5 of the solar cell panel 4 of the solar cell module 6 at room temperature. In addition, the sealant for solar cell panel end 1 need not be heated when the peripheral end 5 of the solar cell panel 4 is fixed to the frame 3, and can easily seal the peripheral end 5 of the solar cell panel 4 of the solar cell module 6.

The sealant for solar cell panel end 1 also has excellent shape stability in a high-temperature atmosphere, and therefore it is possible to prevent dipping when the solar cell panel 4 of the solar cell module 6 is used in a high-temperature atmosphere.
Moreover, the sealant for solar cell panel end 1 also has an excellent insulating property, waterproofness, and flame retardancy, and therefore it is possible to impart an excellent insulating property, waterproofness, and flame retardancy to the peripheral end 5 of the solar cell panel 4 of the solar cell module 6.

In a sealing structure at the peripheral end 5 of the solar cell panel 4 of the solar cell module 6 described above, the peripheral end 5 of the solar cell panel 4 is reliably fixed with the frame 3 via the sealant for solar cell panel end 1, and therefore the peripheral end 5 of the solar cell panel 4 can be more reliably sealed. This allows an improvement in the sealability of the peripheral end 5 of the solar cell panel 4.

In the description given above, when the peripheral end 5 of the solar cell panel 4 is fixed to the frame 3, the sealant for solar cell panel end 1 is stuck first to the peripheral end 5 of the solar cell panel 4. However, the sealant for solar cell panel end 1 can also be stuck first to, e.g., the inner surface of the frame 3, though not shown.

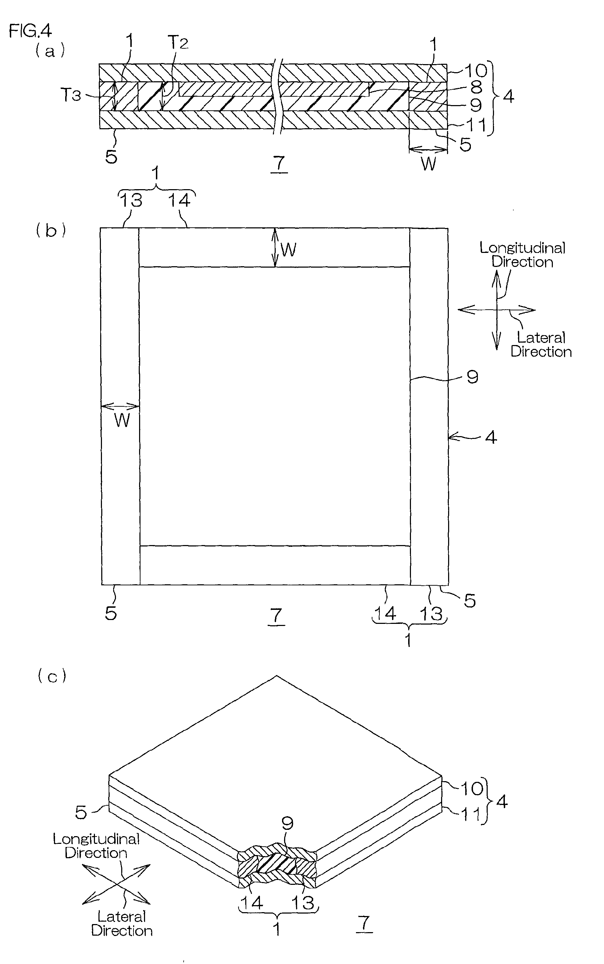

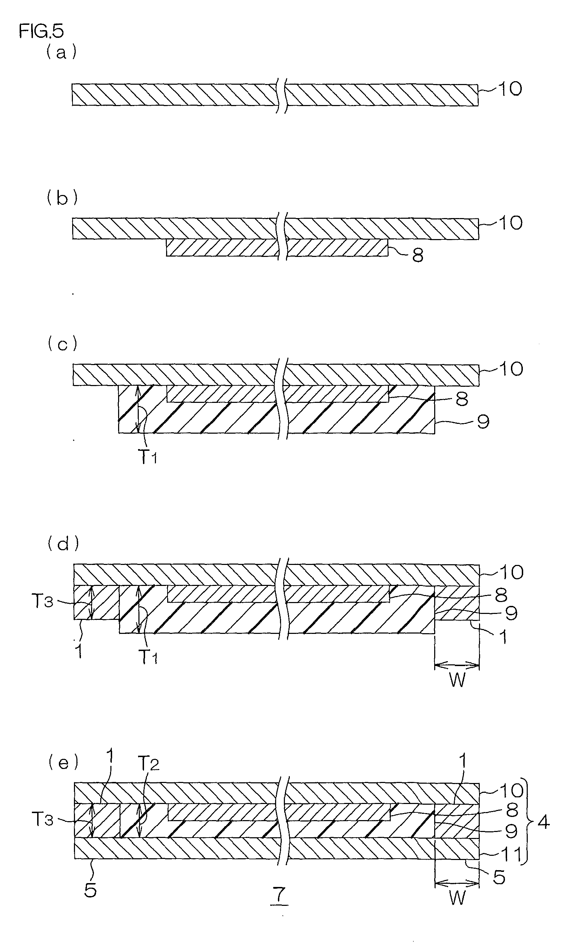

FIG. 4 shows an embodiment (mode in which the sealant for solar cell panel end includes four pieces) of a frameless solar cell module of the present invention. FIG. 5 shows a process step view for illustrating a method of producing the frameless solar cell module shown in FIG. 4(a). FIG. 6 shows a plan view of another embodiment (mode in which the sealant for solar cell panel end includes one piece) of the frameless solar cell module of the present invention.

Note that, in FIGS. 4(b) and 6, the upper covering glass layer 10 is omitted to clearly show the relative positioning of the sealant for solar cell panel end.
In FIG. 4(b), a vertical direction along the surface of the paper is assumed to be a "longitudinal direction", and a traverse direction along the surface of the paper is assumed to be a "lateral direction".
Members corresponding to the members described above are designated by the same reference numerals in each of the subsequent drawings, and a detailed description thereof is omitted.

In the description given above, the sealant for solar cell panel end of the present invention is provided in the solar cell module 6 including the frame 3. However, as shown in FIGS. 4 to 6, the sealant for solar cell panel end of the present invention can also be provided in a frameless solar cell module 7 not including the frame 3.
In FIG. 4, the frameless solar cell module 7 includes the solar cell panel 4, and the sealant for solar cell panel end 1 for filling the peripheral end 5 of the solar cell panel 4.

The solar cell panel 4 includes the solar cell element 8, the sealing resin layer 9, the upper covering glass layer 10, and the lower covering glass layer 11.
The sealing resin layer 9 is disposed in a generally rectangular plan view shape smaller than the upper covering glass layer 10 and the lower covering glass layer 11 so as to be included in the upper covering glass layer 10 and the lower covering glass layer 11 when projected in the thickness direction. That is, the sealing resin layer 9 is provided at the middle in each of the longitudinal and lateral directions (perpendicular directions perpendicular to the thickness direction or directions along the lower surface of the upper covering glass layer 10 and along the upper surface of the lower covering glass layer 11) of the upper covering glass layer 10 and the lower covering glass layer 11 so as to ensure a region where the sealant for solar cell panel end 1 described later is disposed.

The upper covering glass layer 10 is formed such that the peripheral end thereof protrudes outwardly from the sealing resin layer 9. That is, the upper covering glass layer 10 is formed such that the both longitudinal ends and both lateral ends thereof protrude from the sealing resin layer 9 to both outsides in each of the longitudinal and lateral directions.
The lower covering glass layer 11 is formed such that the peripheral end thereof protrudes outwardly from the sealing resin layer 9. That is, the lower covering glass layer 11 is formed such that the both longitudinal ends and both lateral ends thereof protrude from the sealing resin layer 9 to both outsides in each of the longitudinal and lateral directions. The lower covering glass layer 11 is formed such that the peripheral end surface thereof is flush with the peripheral end surface of the upper covering glass layer 10 in the thickness direction.

The sealant for solar cell panel end 1 is disposed so as to surround the sealing resin layer 9 when projected in the thickness direction. Specifically, the sealant for solar cell panel end 1 is disposed so as to come in contact with the outer peripheral surface (both longitudinal end surfaces and both lateral end surfaces) of the sealing resin layer 9.
The sealant for solar cell panel end 1 fills the space between the respective peripheral ends (longitudinal ends and lateral ends) of the upper covering glass layer 10 and the lower covering glass layer 11.

A thickness T3 of the sealant for solar cell panel end 1 is substantially the same as a thickness T2 of the sealing resin layer 9, which is described later.
Next, a method of producing the frameless solar cell module 7 is described with reference to FIGS. 4 and 5.
First in the method, as shown in FIG. 5 (a), the upper covering glass layer 10 is prepared.

Then, as shown in FIG. 5(b), the solar cell element 8 is disposed on the lower surface of the upper covering glass layer 10.
Then, as shown in FIG. 5(c), the sealing resin layer 9 is disposed.
The sealing resin layer 9 is disposed so as to cover the solar cell element 8, and expose the peripheral end of the upper covering glass layer 10.

Since thermocompression described later has not been performed yet, the thickness T1 of the sealing resin layer 9 is set, e.g., large relative to the thickness T3 of the sealant for solar cell panel end 1, and specifically set in a range of, e.g., 0.5 to 2.0 mm, or preferably 0.6 to 1.8 mm.
Then, as shown in FIG. 5(d), the sealant for solar cell panel end 1 is disposed.
As shown in FIG. 4(b), the sealant for solar cell panel end 1 includes two longitudinal sealants 13 each extending long in the longitudinal direction and having a generally rectangular plan view shape, and two lateral sealants 14 contacting the both longitudinal ends of the individual longitudinal sealants 13 and each having a generally rectangular plan view shape extending long in the lateral direction.

The sealant for solar cell panel end 1 is disposed such that the longitudinal sealants 13 are disposed on the lower surfaces of the lateral ends of the upper covering glass layer 10 and the lateral sealants 14 are disposed on the lower surfaces of the longitudinal ends of the upper covering glass layer 10.
The thickness T3 of the sealant for solar cell panel end 1 is, e.g., small relative to the foregoing thickness T1 of the sealing resin layer 9 (sealing resin layer 9 before thermocompression), and specifically in a range of, e.g., 50 to 90%, or preferably 60 to 80% of the thickness T1. More specifically, the thickness T3 of the sealant for solar cell panel end 1 is in a range of, e.g., 0.5 to 1.0 mm, or preferably 0.6 to 0.9 mm.

When the thickness T3 of the sealant for solar cell panel end 1 exceeds the range shown above, workability when the sealant for solar cell panel end 1 is stuck to the lower covering glass layer 11 may deteriorate or gas (e.g., acetic acid gas produced from EVA) produced from the sealing resin layer 9 and/or air may not come out so that air bubbles remain in the sealing resin layer 9.
On the other hand, when the thickness of the sealant for solar cell panel end 1 is less than the range shown above, sufficient sealability may not be able to be ensured for the peripheral end 5 of the solar cell panel 4.

A width W of the sealant for solar cell panel end 1, i.e., the lateral length W of each of the longitudinal sealants 13 and the longitudinal length W of each of the lateral sealants 14 are in a range of, e.g., 0.5 to 2.0 mm, or preferably 1.0 to 2.0 mm.
When the width W of the sealant for solar cell panel end 1 is less than the range shown above, sufficient sealability may not be able to be ensured for the peripheral end 5 of the solar cell panel 4. On the other hand, when the width W of the sealant for solar cell panel end 1 exceeds the range shown above, the installation area of the solar cell element 8 may excessively decrease to reduce electricity generation efficiency.

Thereafter, in the method, as shown in FIG. 5(e), the lower covering glass layer 11 is stuck to the sealing resin layer 9 and the sealant for solar cell panel end 1.
To stick the lower covering glass layer 11 to the sealing resin layer 9 and the sealant for solar cell panel end 1, the lower covering glass layer 11 is brought into contact with the lower surface of the sealing resin layer 9, caused to face upward, and subjected to the thermocompression

Conditions for the thermocompression are such that a temperature is in a range of, e.g., 120 to 150 °C, or preferably 130 to 140 °C (specifically 135 °C), a pressure is in a range of, e.g., 0.05 to 0.5 MPa, or preferably 0.05 to 0.2 MPa (specifically 0.1 MPa), and a thermocompression time is in a range of, e.g., 1 to 60 minutes, or preferably 10 to 30 minutes (specifically 20 minutes).
By the thermocompression, the sealing resin layer 9 is compressed so that the thickness T2 of the sealing resin layer 9 (sealing resin layer 9 after the thermocompression) becomes substantially the same as the thickness T3 of the sealant for solar cell panel end 1.

In this manner, the frameless solar cell module 7 can be obtained in which the peripheral end 5 of the solar cell panel 4 is filled with the sealant for solar cell panel end 1.
The sealant for solar cell panel end 1 has excellent shape stability in a high-temperature atmosphere, and therefore it is possible to prevent dripping to the outside when the lower covering glass layer 11 is stuck thereto by the thermocompression.

In the sealing structure at the peripheral end 5 of the solar cell panel 4 of the frameless solar cell module 7 described above, the sealant for solar cell panel end 1 can be easily stuck to the peripheral end 5 of the solar cell panel 4. This allows easy sealing of the peripheral end 5 of the solar cell panel 4, while achieving reductions in the weight and cost of the frameless solar cell module 7.

Note that the priority of the sealing resin layer in the order of disposition is not particularly limited. For example, it is possible to dispose the sealant for solar cell panel end 1 first, and then successively dispose the solar cell element 8 and the sealing resin layer 9, though not shown.
Alternatively, it is also possible to dispose the solar cell element 8 first, subsequently dispose the sealant for solar cell panel end 1, and then dispose the sealing resin layer 9.

Otherwise, it is also possible to dispose the solar cell element 8 first, and then simultaneously dispose the sealant for solar cell panel end 1 and the sealing resin layer 9.
In the description of FIG. 4(b) given above, the sealant for solar cell panel end 1 is formed of the four sealants (two longitudinal sealants 13 and two lateral sealants 14) each having a generally rectangular plan view shape. However, as shown in FIG. 6, the sealant for solar cell panel end 1 can also be formed of one sealant.

In FIG. 6, the sealant for solar cell panel end 1 is continuously formed in a generally rectangular frame shape when viewed in plan view.
The sealant for solar cell panel end 1 can be obtained by, e.g., being formed into a generally rectangular plan view shape using, e.g., the molding device mentioned above, though not shown, and then punching the middle (longitudinal middle and lateral middle) thereof.

### EXAMPLES

While in the following, the present invention is described more specifically with reference to Examples and Comparative Examples, the present invention is not limited to any of them.

### Example 1

### (Production of Sealant for Solar Cell Panel End)

In accordance with the blending formulation shown in Table 1, the individual components shown in Table 1 were loaded into a kneader (Model DS1-5GHB-E, 1-L kneader with 6-inch Open Roll available from Moriyama Company Ltd.), and kneaded by a master batch method to prepare a kneaded product.

Specifically, one-half (250 parts by weight) of the total amount of aluminum hydroxide and each of the components other than aluminum hydroxide and softeners (polybutene and oil) were loaded into the kneader, and kneaded at 90 °C for 20 minutes to prepare a master batch. Thereafter, the remaining amount (250 parts by weight) of aluminum hydroxide and the softeners (87 parts by weight of polybutene and 53 parts by weight of oil) were further loaded to be added to the master batch, and the resulting mixture was kneaded at 90 °C for 20 minutes to obtain a kneaded product having an elongated (ribbon) shape.

The obtained kneaded product was extrusion-molded to a thickness of 1 mm with an extruder (45-V extruder available from Nakata Engineering Co., Ltd.) to obtain a sealant for solar cell panel end. Extrusion conditions for the extruder were set such that a cylinder upstream temperature was 45 °C, a cylinder downstream temperature was 50 °C, a screw temperature was 45 °C, and a head temperature was 50 °C, and the number of screw revolutions was set to 15 (1/min).

The obtained sealant for solar cell panel end was laminated on a surface of an exfoliate film, and another exfoliate film was further laminated on the surface of the sealant for solar cell panel end to form the exfoliate films on the both surfaces of the sealant for solar cell panel end (see FIG. 1).

### Example 2

A sealant for solar cell panel end was obtained in the same manner as in Example 1 except that the number of parts of blended aluminum hydroxide was changed to 100 parts by weight.

Specifically, in the blending of aluminum hydroxide in the master batch method, 50 parts by weight of aluminum hydroxide, corresponding to one-half of the total amount thereof, was loaded first to prepare a master batch, and another 50 parts by weight of aluminum hydroxide, corresponding to the remaining one-half thereof, was further loaded to be added to the obtained master batch.
The extrusion conditions for the extruder were set such that the cylinder upstream temperature was 40 °C, the cylinder downstream temperature was 45 °C, the screw temperature was 35 °C, and the head temperature was 50 °C, and the number of screw revolutions was set to 20 (1/min).

### Example 3

A sealant for solar cell panel end was obtained in the same manner as in Example 1 except that the respective numbers of parts of blended polybutene and oil were changed to 31 parts by weight and 19 parts by weight and, instead of the extruder, a calender roll (8-inch diameter by 24-inch long inverted L-type 4-roll precision calender roll machine available from Hitachi, Ltd.) was used.

Note that heating conditions for the calender roll included a temperature of 90 °C.

### Example 4

A sealant for solar cell panel end was obtained in the same manner as in Example 1 except that the respective numbers of parts of blended polybutene and oil were changed to 155 parts by weight and 95 parts by weight. Note that, in this case, the extrusion conditions for the extruder were set the same as in Example 2.

### Comparative Example 1

A sealant for solar cell panel end was obtained in the same manner as in Example 1 except that the number of parts of blended aluminum hydroxide was changed to 50 parts by weight.
Specifically, in the blending of aluminum hydroxide in the master batch method, 25 parts by weight of aluminum hydroxide, corresponding to one-half of the total amount thereof, was loaded first to prepare a master batch, and another 25 parts by weight of aluminum hydroxide, corresponding to the remaining one-half thereof, was further loaded to be added to the obtained master batch.

### Comparative Example 2

A sealant for solar cell panel end was obtained in the same manner as in Example 1 except that the number of parts of aluminum hydroxide was changed to 700 parts by weight, and a heat presser (Mini Test Press-10 available from Toyo Seiki Co., Ltd.) was used instead of the extruder.
Specifically, in the blending of aluminum hydroxide in the master batch method, 350 parts by weight of aluminum hydroxide, corresponding to one-half of the total amount thereof, was loaded first to prepare a master batch, and another 350 parts by weight of aluminum hydroxide, corresponding to the remaining one-half thereof, was further loaded to be added to the obtained master batch.

Note that heat pressing conditions for the heat presser were set such that the temperature was 100 °C, and a pressing pressure was 10 MPa.
Note that it was attempted to mold the kneaded product resulting from kneading in accordance with the blending formulation of Comparative Example 2 using each of the extruder and the calender roll. However, the kneaded product could not be extrusion-molded with the extruder due to the excessively high viscosity thereof. The kneaded product could not also be roll-molded with the calender roll due to the excessively high adhesion (tuck) thereof and an unsatisfactory roll release property.

### Comparative Example 3

Terostat 2780 (hot melt butyl, 1 mm thick product available from Henkel Corporation for exclusive use in solar cell panel) was used without any alteration as a sealant for solar cell panel end of Comparative Example 3.

### (Evaluation)

The sealants for solar cell panel end obtained in Examples and Comparative Examples were each evaluated for each of the items of a flame retardancy test, a waterproofness test, a dielectric breakdown voltage test, and a viscoelasticity test. The results of the evaluations are shown in Table 1.

Note that, due to considerable difficulty experienced in retaining the shape of the sealant for solar cell panel end of Comparative Example 2, an evaluation thereof could not be performed for any of the items shown above.

### (1) Flame Retardancy Test (Oxygen Index)

For each of specimens obtained above, an oxygen index was measured in accordance with JIS K6269.

### (2) Waterproofness Test

Each of sealants for solar cell panel end (1) was molded again with a heat presser to a thickness of 0.8 mm, and subsequently worked to obtain a 300 mm long by 10 mm wide specimen. The specimen was formed into an upwardly open U-shaped shape, as shown in FIG. 7. Then, the specimen was sandwiched between two holding plates (19 and 20) (acrylic resin plate 19 and aluminum plate 20 each punched into a size of 150 mm x 150 mm), and the sealant for solar cell panel end (1) between the holding plates (19 and 20) was filled with water so as to achieve a water depth of 100 mm. Thereafter, by checking the presence or absence of water leakage from the sealant for solar cell panel end (1), waterproofness was evaluated.

In Table 1, "Excellent." shows that there was no water leakage, and "Poor" shows that there was a water leakage.

### (3) Dielectric Breakdown Voltage Test (Insulating Property)

On each of the sealants for solar cell panel end, a dielectric breakdown voltage test described in JIS C2110 was performed. A voltage increasing rate and a distance between electrodes were set to 500 V/second and 1 mm, respectively.

### (4) Viscoelasticity Test

Each of the sealants for solar cell panel end was worked into a size of a diameter of 7.5 mm to obtain a specimen. The obtained specimen was subjected to measurement with a viscoelasticity measuring device (available from Rheometrics Co., Ltd. under the trade name of ARES), and the storage shear modulus G', loss shear modulus G", and loss tangent tanδ thereof were calculated. Measurement conditions were set such that a temperature increasing rate was 5 °C/minute, a temperature range was -40 to 120 °C, a frequency was 1.0 Hz, and a distortion was 0.1%.

### EXAMPLES

The graph of the storage shear moduli G' is shown in FIG. 8. The graph of the loss shear moduli G" was shown in FIG. 9. The graph of the loss tangents tanδ was shown in FIG. 10.

Table 1

**Table 1**

| | Exs./ Comp. Exs. | | | Ex. 1 | Ex. 2 | Ex. 3 | Ex. 4 | Comp. Ex. 1 | Comp. Ex. 2 | Comp. Ex.3 |
|---|---|---|---|---|---|---|---|---|---|---|
| Blending Formulation of Sealant for Solar Cell Panel End (Parts by Weight) | Aluminum Hydroxide | | | 500 | 100 | 500 | 500 | 50 | 700 | (Terostat 2780) |
| | Polyisobutylene | | | 100 | 100 | 100 | 100 | 100 | 100 | |
| | Polybutene | | | 87 | 87 | 31 | 155 | 87 | 87 | |
| | Oil | | | 53 | 53 | 19 | 95 | 53 | 53 | |
| | Calcium Carbonate | | | 4.5 | 4.5 | 4.5 | 4.5 | 4.5 | 4.5 | |
| | Carbon Black | | | 3 | 3 | 3 | 3 | 3 | 3 | |
| | Fatty Acid | | | 0.8 | 0.8 | 0.8 | 0.8 | 0.8 | 0.8 | |
| | Irganox 1010 | | | 1.5 | 1.5 | 1.5 | 1.5 | 1.5 | 1.5 | |
| Evaluation | Flame Retardancy | | Oxygen Index | 31.6 | 20.2 | 44.9 | 25.0 | 18.4 | (Evaluation Was Impossible Due to Difficulty Retaining Shape) | 19.2 |
| | Waterproofness | | Waterproofness | Excellent | Excellent | Excellent | Excellent | Excellent | | Poor |
| | Insulating Property | | Dielectric Breakdown Voltage (V) | 18.8 | 22.5 | 24.6 | 13.6 | 22.5 | | 15 |
| | Visco-Elasticity | Storage Shear Modulus G' (Pa) | 0 °C | 3.7 x 10⁵ | 1.4 x 10⁵ | 9.0 x 10⁵ | 2.5 x 10⁵ | 1.0 x 10⁵ | | 5.5 x 10⁶ |
| | | | 100 °C | 6.7 x 10⁴ | 5.6 x 10⁴ | 3.0 x 10⁵ | 5.7 x 10⁴ | 5.1 x 10⁴ | | 2.4 x 10⁴ |
| | | Storage Loss Modulus G" (Pa) | 0 °C | 2.1 x 10⁵ | 5.8 x 10⁴ | 4.4 x 10⁵ | 1.4 x 10⁵ | 3.7 x 10⁴ | | 6.6 x 10⁶ |
| | | | 100 °C | 1.2 x 10⁵ | 2.6 x 10⁴ | 3.0 x 10⁵ | 4.6 x 10⁴ | 2.2 x 10⁴ | | 2.3 x 10⁴ |
| | | tanδ (= G"/G') | 0 °C | 0.6 | 0.4 | 0.5 | 0.6 | 0.4 | | 1.2 |
| | | | 100 °C | 1.9 | 0.5 | 1.0 | 0.8 | 0.4 | | 1.0 |

Details of each of the components in Table 1 are shown below.
Aluminum Hydroxide: Higilite H-42T having an average particle size of 1.1 µm, and available from Showa Denko KK
Polyisobutylene: Oppanol B-100EP, liquid butene having a viscosity-average molecular weight of 1100000, and available from BASF Corporation
Oil: Comolex F22, softener, naphthene-based oil available from Nippon Petrochemicals Co., Ltd.
Carbon Black: Seast 3H available from Tokai Carbon Co., Ltd.
Fatty Acid: Sakura, tallow hardened fatty acid (stearic acid powder) available from NOF Corporation
Irganox 1010: antiaging agent available from Chiba Specialty Chemicals Inc.
Terostat 2780: hot melt butyl available from Henkel Corporation (product for exclusive use in solar cell panel)
While the illustrative embodiments of the present invention are provided in the above description, such is for illustrative purpose only and it is not to be construed limitative. Modification and variation of the present invention which will be obvious to those skilled in the art is to be covered by the following claims.

### Industrial Applicability

A sealant for solar cell panel end is used to seal a solar cell module and/or a frameless solar cell module.

## Claims

1. A sealant for solar cell panel end for sealing an end of a solar cell panel, comprising:
100 parts by weight of polyisobutylene and/or butyl rubber; and
100 to 600 parts by weight of a metal hydroxide.

2. The sealant for solar cell panel end according to claim 1, further comprising:
100 to 200 parts by weight of a softener based on 100 parts by weight of the polyisobutylene and/or the butyl rubber.

3. The sealant for solar cell panel end according to claim 1, wherein a storage shear modulus (G') is not less than 3 x 10⁴ and not more than 2 x 10⁶ in a temperature range of 0 to 100 °C.

4. The sealant for solar cell panel end according to claim 1, wherein a dielectric breakdown voltage measured based on a dielectric breakdown voltage test defined in JIS C2110 is not less than 8 kV.

5. A solar cell module, comprising:
a solar cell panel;
a sealant for solar cell panel end which seals an end of the solar cell panel, and comprises 100 parts by weight of polyisobutylene and/or butyl rubber, and 100 to 600 parts by weight of a metal hydroxide; and
a fixing member which fixes the end of the solar cell panel via the sealant for solar cell panel end.

6. The solar cell module according to claim 5, wherein
the solar cell panel comprises:
a solar cell element;
a sealing resin layer which seals the solar cell element; and
a covering glass layer which covers the sealing resin layer on both sides thereof in a thickness direction, wherein
the sealant for solar cell panel end is stuck continuously to at least a side surface of the sealing resin layer and a side surface of the covering glass layer.

7. A frameless solar cell module, comprising:
a solar cell panel; and
a sealant for solar cell panel end which seals an end of the solar cell panel, and comprises 100 parts by weight of polyisobutylene and/or butyl rubber, and 100 to 600 parts by weight of a metal hydroxide.

8. The frameless solar cell module according to claim 7, wherein
the solar cell panel comprises:
a solar cell element;
a sealing resin layer sealing the solar cell element; and
a covering glass layer which covers the sealing resin layer on both sides thereof in a thickness direction, and has a perpendicular end perpendicular to the thickness direction and protruding from the sealing resin layer, and
the sealant for solar cell panel end is disposed so as to surround the sealing resin layer when projected in the thickness direction, and fills the perpendicular end of the covering glass layer.

9. A sealing structure at solar cell panel end, wherein an end of a solar cell panel is fixed with a fixing member via a sealant for solar cell panel end comprising 100 parts by weight of polyisobutylene and/or butyl rubber, and 100 to 600 parts by weight of a metal hydroxide.

10. A sealing structure at solar cell panel end, wherein an end of a solar cell panel is filled with a sealant for solar cell panel end comprising 100 parts by weight of polyisobutylene and/or butyl rubber, and 100 to 600 parts by weight of a metal hydroxide.
